(19) Europäisches Patentamt
European Patent Office
Office européen des brevets

(11) EP 1 837 670 B1

(12) **EUROPEAN PATENT SPECIFICATION**

(45) Date of publication and mention
of the grant of the patent:
**03.01.2018 Bulletin 2018/01**

(51) Int Cl.:
*G01R 31/36* *(2006.01)* *H03M 1/10* *(2006.01)*

(21) Application number: **06114800.3**

(22) Date of filing: **31.05.2006**

(54) **Fault detection method and apparatus**

Verfahren und Vorrichtung zur Fehlerdetektion

Procédé et appareil de détection de défauts

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **24.03.2006 US 785537 P**

(43) Date of publication of application:
**26.09.2007 Bulletin 2007/39**

(73) Proprietor: **Rockwell Automation Limited
Milton Keynes
Buckinghamshire MK11 3DR (GB)**

(72) Inventor: **Meagher, Thomas, Bruce
Houston, TX 77084 (US)**

(74) Representative: **Williams, Michael David
Marks & Clerk LLP
1 New York Street
Manchester M1 4HD (GB)**

(56) References cited:
**EP-A2- 0 458 515        DE-A1- 19 750 349
US-A- 4 539 683         US-A- 4 679 028
US-A- 5 552 881         US-A- 5 594 439
US-A1- 2003 063 679     US-B1- 6 351 835**

• **MING J ET AL: "AN 8B 80MSAMPLE/S PIPELINED
ADC WITH BACKGROUND CALIBRATION", IEEE:
INTERNATIONAL SOLID - STATE CIRCUITS
CONFERENCE, XX, XX, 7 February 2000
(2000-02-07), page 42/43, XP002949447,**

**Description**

BACKGROUND

a. Field of the Invention

This invention relates to fault detection in electrical circuits, in particular it relates to fault detection for a plurality of adjacent input circuits.

In safety control systems, fault tolerance is of utmost importance. Fault tolerance is the ability to continue functioning in the event of one or more failures within the system.

Fault tolerance may be achieved by a number of different techniques, each with its specific advantages and disadvantages. One example of fault tolerance is known as Hardware Implemented Fault Tolerance (HIFT). HIFT means that the system relies on robust hardware circuits (as opposed to complex software algorithms) to perform the fault detection and redundancy management functions. A significant advantage HIFT has over software-implemented fault tolerance is that HIFT eliminates the overhead for communications between processors, leaving more time for controlling the process. This makes HIFT systems significantly faster and more dependable than systems using software-implemented fault tolerance.

An example of a HIFT system is a system which provides redundancy, in particular Triple Modular Redundancy (TMR). Using TMR, critical circuits are triplicated and perform identical functions simultaneously and independently. The data output from each of the three circuits is voted in a majority-voting circuit, before affecting the system's outputs. If one of the triplicated circuits fails, its data output is ignored. However, the system continues to output to the process the value (voltage, current level, or discrete output state) that agrees with the majority of the functional circuits. TMR provides continuous, predictable operation.

HIFT and TMR provides for automatic fault recovery with no disruption to system operation and ensures minimal fault detection periods.

Another approach to fault tolerance is the use of hot-standby modules. This approach provides a level of fault tolerance whereby the standby module maintains system operation in the event of module failure. With this approach there may be some disruption to system operation during the changeover period if the modules are not themselves fault-tolerant.

Fault tolerant systems ideally create a Fault Containment Region (FCR) to ensure that a fault within the FCR boundary does not propagate to the remainder of the system. This enables multiple faults to co-exist on different parts of a system without affecting operation.

Fault tolerant systems generally employ dedicated hardware and software test and diagnostic regimes that provide very fast fault recognition and response times to provide a safer system.

Commonly, it is possible to repair faults without interrupting system operation (known as hot replacement). For example active and standby module may operate in parallel so that if an active module becomes faulty there is an automatic change over to a standby module.

Safety control systems are generally designed to be 'fail-operational/fail-safe'. Fail operational means that when a failure occurs, the system continues to operate: it is in a fail-operational state. The system should continue to operate in this state until the failed module is replaced and the system is returned to a fully operational state.

An example of fail safe operation occurs, for example if, in a TMR system, a failed module is not replaced before a second failure in a parallel circuit occurs, the second failure should cause the TMR system to shut down to a fail-safe state.

Typical safety control applications include emergency and safety shutdown systems, process control, reactor control, wellhead control, turbine and compressor control, fire and gas detection and abatement, and are applicable to many industries including oil and gas production and refining, chemical production and processing, power generation, paper and textile mills and sewage treatment plants.

Patent application number DE 197 50 349 discloses an analyser comprising a multiple sine wave signal generator operating with a sample signal generator, D-A converters, low pass filters and a quadrature modulator to produce a signal consisting of a synthesis of several sine waves of different frequencies within a chosen band. This signal is applied to the DUT i.e. component or equipment under test. The ouput signal then transmitted from the DUT to the analyser is converted to a digital value through an A-D converter, and fed into a signal processor where it is conducted through a quadrature analysis section and fast Fourier transformation to the phase/amplitude comparator for evaluation.
In DE 197 50 349 the unit under test is tested using a multiple sine wave. However, there is no possibility of testing the unit while the unit is actually in use.

US patent No 6,351,835 discloses a testing apparatus for large scle integrated circuit dvices in which a test sequence generator produces a sequence of test signals each having a different test pattern, and in which spectral component of a surce current a observed when the device is avated by test sinals. Again there is no suggestion as to how a device might be tested whilst actually in use.

SUMMARY OF THE INVENTION

According to the invention there is provided a method of testing an input circuit for receiving an input signal and producing an output signal, the method comprising the steps of: generating a periodic test signal having a predetermined phase and a predetermined amplitude; summing the test signal and an input signal to provide a summed signal; processing the summed signal by the input circuit to provide an output signal; generating an extracted test signal from the output signal; comparing the extracted test signal with a reference signal representing said periodic test signal; generating an error signal in dependence upon the result of said comparing step characterised in that the output signal is sampled at a sampling period and the samples are averaged over a moving average time period equal to an integer multiple of the period of the test signal.

In a preferred embodiment the test signal is a sinusoidal signal.

Preferably, the moving average time period is equal to the period of the test signal. Even more preferably the period of the test signal is 4ms; the output signal is sampled every 1 ms, and an average of the previous four samples is generated every 1ms.

In one embodiment of the invention a plurality of independent input circuits are tested according to the method of any one of the preceding claims and in which a plurality of test signals are generated by a method comprising the steps of; generating a digital representation of a periodic test signal, the digital representation comprising a number of bits equal to the number of test signals to be generated; storing said digital representation in a shift register; generating a plurality of digital test signals from a plurality of taps from the shift register such that each digital test signal comprises a uniquely phased digital pattern; low pass filtering each digital test signal to generate a plurality of unique analogue test signals.

Preferably a first test signal used to test a first input circuit is arranged to have as great a phase separation as possible from a second test signal used to test a second adjacent input circuit.

According to another aspect of the invention there is provided a method of detecting in input fault in replicated input circuits in which the replicated input circuits are all arranged to receive a single input signal, the method comprising the steps of: generating an error signal for each replicated circuit as described previously, and wherein a test signal for each replicated input circuit is arranged to have a small frequency difference with a test signal for each other replicated circuit such that in the event of one of the input circuits having an open circuit input the resulting output signal will exhibit a significant amplitude variation due to said test signals beating against one another.

Preferably. the frequency difference between the test signals for replicated input circuits is substantially equal to 0.2%.

According to another aspect of the invention there is also provided an apparatus for testing an input circuit for receiving an input signal and producing an output signal, the apparatus comprising: means for generating a periodic test signal having a predetermined phase and a predetermined amplitude; an adder for summing the test signal and an input signal to provide a summed signal; means for processing the summed signal to provide an output signal; means for generating an extracted test signal from the output signal; a comparator for comparing the extracted test signal with a reference signal representing said periodic test signal and for generating an error signal in dependence upon said comparison characterised in that the periodic test signal comprises a symmetrical signal and in which the output signal is sampled and the samples are averaged over a moving average time period equal to an integer multiple of the period of the test signal and in which the sample period is such that the average value of the contribution from the test signal over said moving average period is equal to zero.

## BRIEF DESCRIPTION OF THE DRAWINGS

The invention will now be described, by way of example only, with reference to the accompanying drawings in which:

Figure 1 illustrates schematically a fault tolerant architecture;
Figure 2 illustrates a sigma-delta input circuit;
Figure 3 illustrates generation of digital test signals;
Figures 4a to 4d illustrates tests signals before and after low pass filtering;
Figure 5 illustrates the removal of the test signals from the true signal by block averaging;
Figure 6 illustrates a typical beat pattern when two signals of similar phase interfere with one another; and
Figure 7 illustrates generation of a digital signal representing an input analogue signal and a signal representing an input test signal from a serial digital signal.

## DETAILED DESCRIPTION

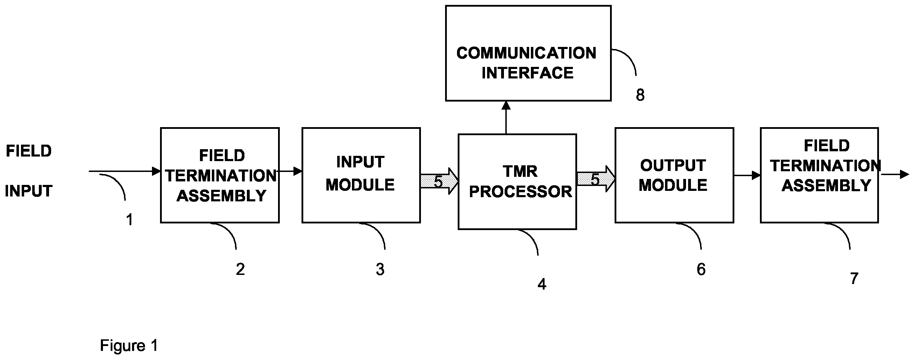

Referring now to Figure 1, signals 1 from an input field device (not shown) are connected to the system via an input Field Termination Assembly (FTA) 2. An input module 3 receives, buffers and carries out any necessary conversion of the input data from the field device. The input data is then transmitted over a triplicated Inter-Module Bus (IMB) 5 to a TMR processor 4. Triplicated microprocessors of the TMR processor receive the input data from each channel of the IMB 5 and carry out a majority vote of the data. During data processing, each of the three processors compares and majority votes its input data against that of the other two processors. The processors synchronously execute the application program, and the derived output data is transmitted back to the IMB. An output module 6 receives, majority votes, and carries out any necessary conversion of the output data from the TMR processor 4. The output circuits are then driven by the majority-voted command. The output signals are connected to a field device (not shown) via an output FTA 7. A communications interface 8 provides facilities to allow systems to be networked using peer to peer communications links, the collection of Sequence of Events (SOE) data, and connection to other systems.

If an internal circuit in the system fails, it is simply voted out. Comprehensive distributed voting both out-votes failures, preventing them from being propagated into the process, and simplifies the process of identifying where faults have occurred by means identifying the source of a discrepant value.

For safety systems it is beneficial for line monitored analogue and digital input modules to detect open circuit faults between the Field Termination Assembly (FTA) and the input module itself. The requirement also exists that any fault in the components of each input circuit should be detectable.

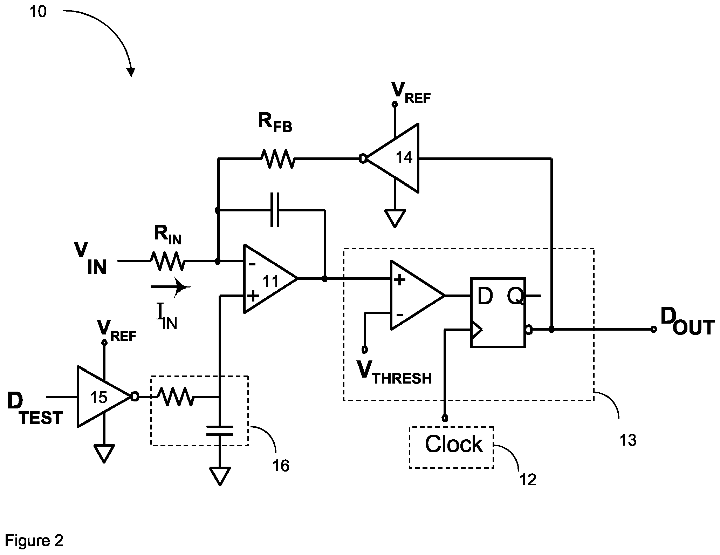

Figure 2 illustrates a sigma-delta analogue to digital (A/D) converter 10 used by the input module 3. The input module 3 comprises an array of 42x3 triplicated sigma-delta A/D converters 10. There is a dedicated A/D converter for each of the three input 'slices'. To maximize fault detection no buffers are inserted in the signal path.

The sigma-delta A/D converter 10 comprises an integrator 11, a one-bit A/D converter 13 and a one-bit D/A converter 14. A test signal $D_{TEST}$ is converted by a one-bit D/A converter 15 and connected to a first input of the integrator 11 via an RC low pass filter 16. An input scaling resistor $R_{IN}$ connects an input $V_{IN}$ of the module to a second inverting input of the integrator 11. The output of the integrator 11 is converted to a digital output by the one-bit A/D converter 13. The one-bit D/A converter 14 feeds back an analogue version of the digital output to the inverting input via a feed back resistor $R_{FB}$.

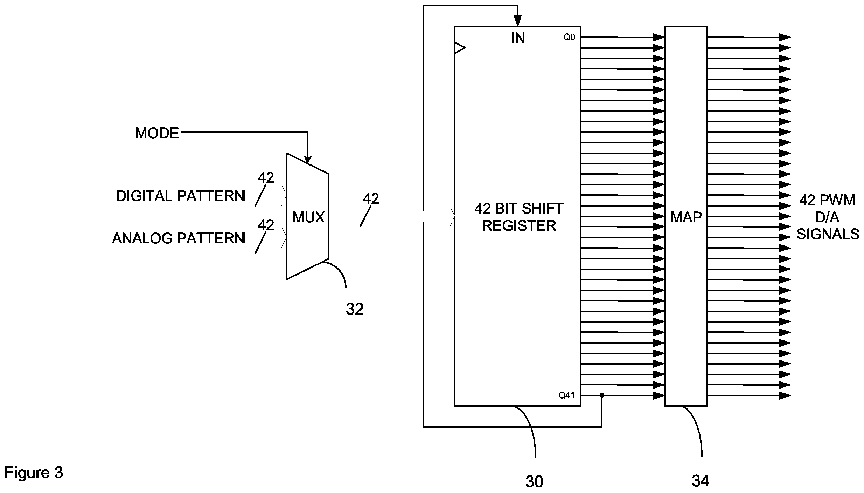

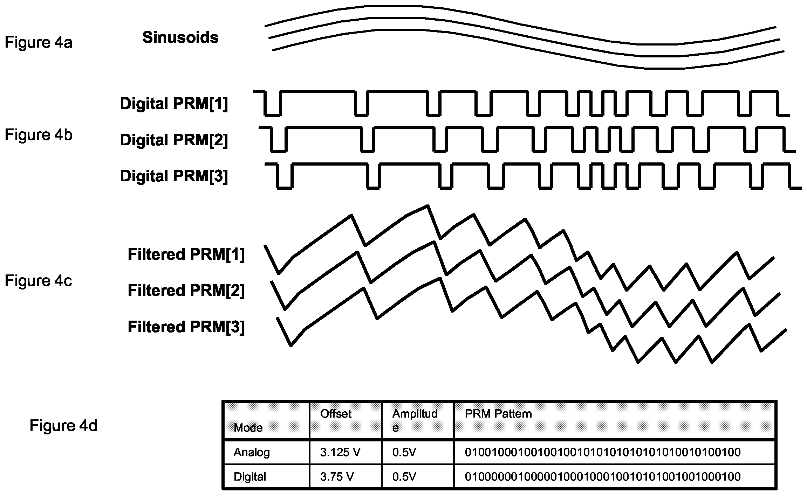

Generation of test signal $D_{TEST}$ will now be described, with reference to Figure 3. The $D_{TEST}$ digital test signal is produced by an FPGA (not shown) and is unique for each of the 42x3 A/D circuits 10. A pattern of forty-two one's and zero's is stored in the FPGA and is circulated through a forty two bit shift register 30. The ratio of one's to zeros in the circulating digital pattern produces an average DC offset for an array of channels. Different patterns, for example as shown in Figure 4d, are used for different input module types (eg analogue or digital) generating a different offset, allowing the centre point of the input voltage span to be tailored to suit the purpose of the module. The pattern to be used is selected using a multiplexer 32. Each tap of the shift register 30 produces a uniquely phased digital pattern as shown in Figure 4b. Each data stream is filtered via the D/A converter 15 and RC filter 16 shown in Figure 2, and forty two unique roughly sinusoidal signals are produced, as shown in Figure 4c.

It is an advantage if the data stream is divided into segments which are averaged in order to remove the test signal from the final output signal.

In the preferred embodiment the system provides a new input channel result every millisecond. The final result is a boxcar average of the four previous results. The test signal is programmed to periodically repeat at a four millisecond rate, so that it is effectively eliminated from the output signal.

In other embodiments the test signal repeats at a frequency equal to or an integral multiple of the frequency of a moving average (or boxcar) function and the sample period is arranged such that the average of the test signal over the moving average period is equal to zero.

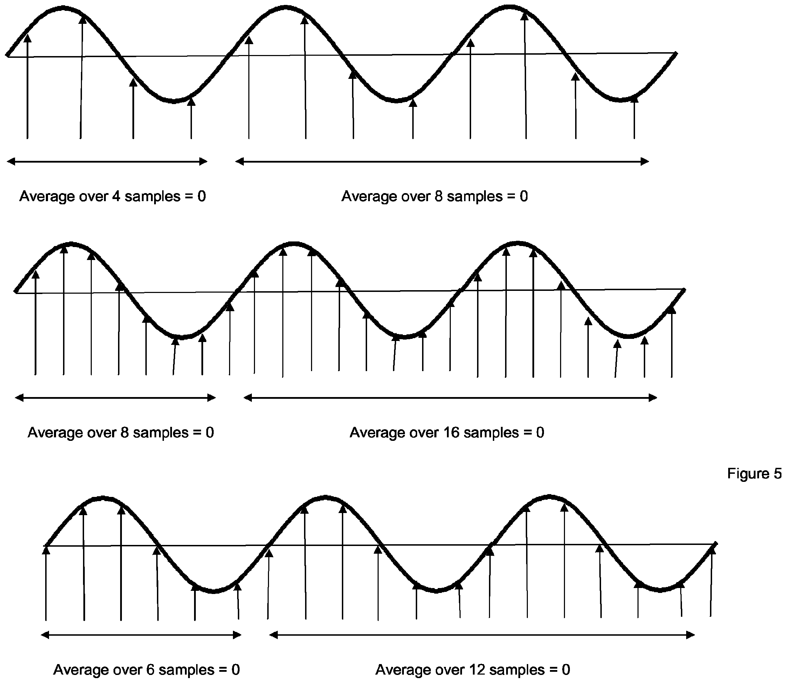

Because of the symmetry of a sinusoidal test signal numerous arrangements are possible. Examples of possible arrangements are shown in Figure 5.

It will be appreciated that other forms of periodic test signal could also be use so long as the sample frequency and sample period is arranged such that the resulting average of the contribution by the test signal is equal to zero.

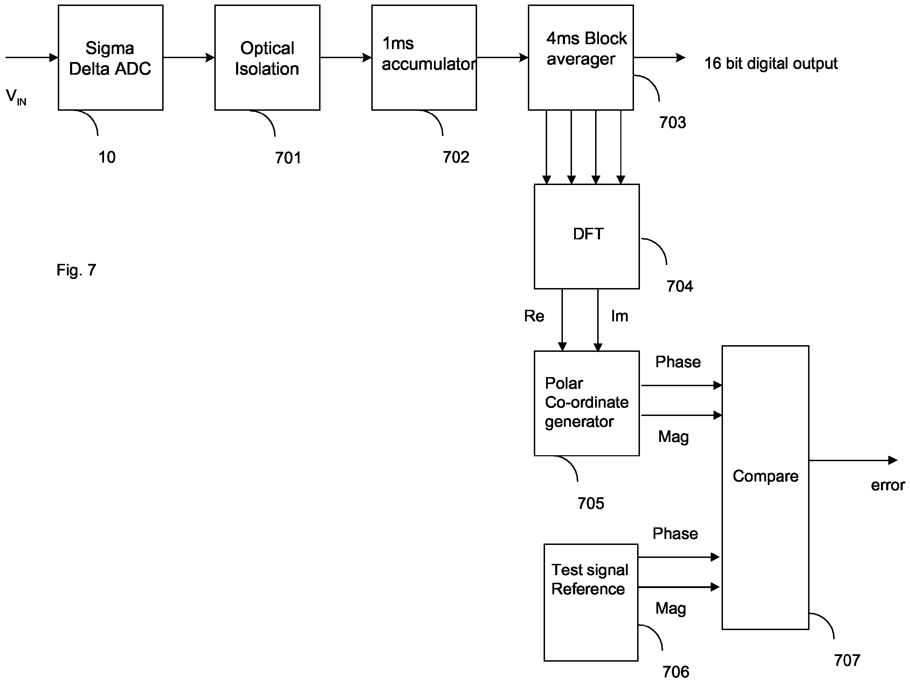

Referring now to Figure 7 which illustrates production of an output test signal, a serial binary sampled values are optically isolated from the output signal by an optical isolator 701. Isolated serial binary output samples are accumulated for 1 ms synchronously with the test signal phase by an accumulator 702. A 16 bit sample value is presented to a block averager 703 every ms. Four consecutive samples are averaged every ms to generate a digital output representing the analogue input.

The test signal is extracted by sending quadrant samples Sample(0), Sample(1), Sample(2), Sample(3) to a Discrete Fourier Transformer (DFT) 704. In the preferred embodiment a simple four point DFT is used so:

$$\mathrm{SIGNAL}_{RE} = \mathrm{Sample}(0) - \mathrm{Sample}(2)$$

$$\mathrm{SIGNAL}_{IM} = \mathrm{Sample}(1) - \mathrm{Sample}(3)$$

Although in other embodiments using more samples more complex DFT calculations will be required.

A polar co-ordinate generator 705 generates the phase and magnitude of the test signal for comparison with previously stored reference signals 706. A comparator 707 continuously compares the measured test signal with the reference value and generates an error condition in the event that an error is detected.

The test signals are calibrated by connecting all the inputs to a low resistance source and measuring the test signal amplitudes and phases for several seconds. These values are stored in the test signal reference memory 706 for continuous comparison during normal operating mode (see Figure 7).

If two separate input channels become shorted together, then the phase and magnitudes of their measured test signals deviate from the stored reference values and this is reported as a channel independence fault. Since adjacent channels are more likely to short together than non adjacent channels, a mapping function block 34 shown in Figure 3 is used to provide greatest phase separation for adjacent channels.

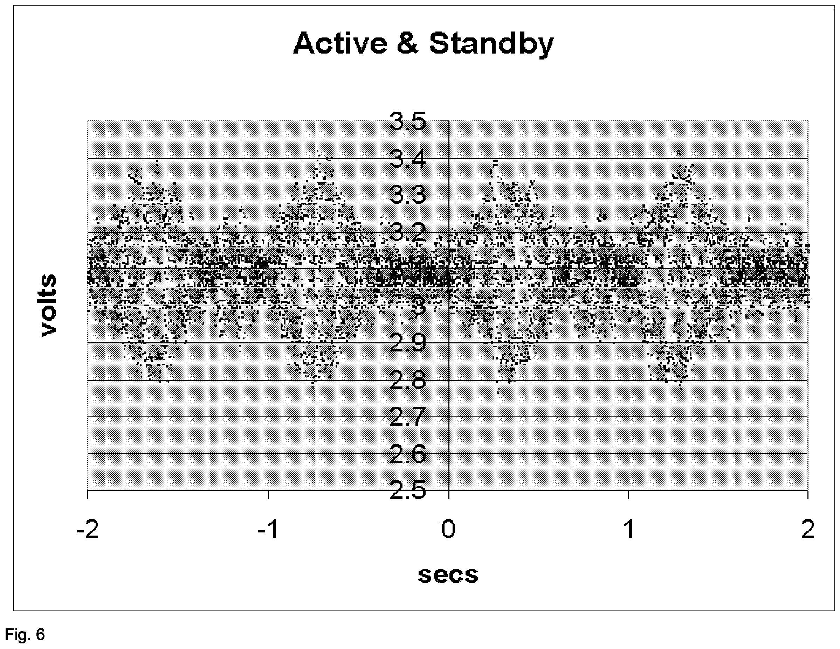

The three slices are connected together and to $V_{IN}$ at their input resistors. If the wire between the input module and the FTA is broken, then this junction is a high impedance, and the test signal from each slice is imposed upon it. The frequencies of operation of each slice are shifted by 0.2% from each other by virtue of a programmable frequency synthesizer in the FPGA. When an input is floating the test signals of all the slices that are connected to the input node (and are powered up) beat against each other, ie because of the similarity of the phase a distinctive variation in amplitude of the combined signal is observed, creating a pattern that is easily recognisable. This is shown in Figure 6.

One feature of this approach is that when standby modules are inserted in parallel to the active module, and six slices are connected to each input, the beat frequency signal components become greater because each of the six slices is running at its own unique frequency.

The technique described here uses a continuos test signal with a unique phase and frequency for each input channel of each triplicated slice. The phase and amplitude of the test signals are extracted via quadrature signal processing and compared to stored reference values. By performing simple statistical analysis on the test signal phase and magnitude variation history it is possible to identify input channel slices that have open input faults, channel independence faults, as well as other component failures.

It is to be recognised that various alterations, modifications, and/or additions may be introduced into the constructions and arrangements of parts described above without departing from the scope of the present invention as defined in the following claims.

**Claims**

1. A method of testing a first input circuit for receiving an analog input signal ($V_{IN}$) and producing a digital output signal, the method comprising the steps of:

   generating a first periodic test signal ($D_{TEST}$) having a predetermined phase and a predetermined amplitude;
   **characterized in that** the method for further comprises the steps of:

   summing the first periodic test signal ($D_{TEST}$) and the analog input signal ($V_{IN}$) to provide a summed signal, the first periodic test signal ($D_{TEST}$) comprising a symmetrical signal;
   processing the summed signal by the input circuit to provide a signal ($D_{OUT}$);
   producing the digital output signal from the signal ($D_{OUT}$), wherein producing the digital output signal comprises sampling the signal ($D_{OUT}$) and averaging samples of the signal ($D_{OUT}$) over a moving average time period equal to an integer multiple of the period of the periodic test signal ($D_{TEST}$) such that the average value of the contribution from the periodic test signal ($D_{TEST}$) to the digital output signal over said moving average period is equal to zero;
   generating an extracted test signal from the samples of the signal ($D_{OUT}$);
   comparing the extracted test signal with a reference signal (706) representing said first periodic test signal ($D_{TEST}$); and
   generating an error signal in dependence upon the result of the said comparing step.

2. A method according to claim 1, in which the first periodic test signal ($D_{TEST}$) is a sinusoidal signal.

3. A method according to claim 1, in which the moving average time period is equal to the period of the first periodic test signal ($D_{TEST}$).

4. A method according to any one of the preceding claims in which the period of the first periodic test signal ($D_{TEST}$) is 4ms; the signal ($D_{OUT}$) is sampled every 1 ms, and the moving average of the previous four samples is generated every 1ms such that the moving average time period is 4 ms.

5. A method according to any one of the preceding claims in which a plurality of further input circuits are tested, said input circuits being similar in structure to the first input circuit, the method further comprising:

   generating a plurality of further periodic test signals ($D_{TEST}$) each provided to a respective one of the plurality of the further input circuits, wherein generating the plurality of the further periodic test signals ($D_{TEST}$) comprises:

   generating a digital representation, the digital representation comprising a number of bits equal to the number of the plurality of the first and further periodic test signals ($D_{TEST}$) to be generated;
   storing said digital representation in a shift register (30);
   generating a plurality of digital test signals from a plurality of taps from the shift register (30) such that each digital test signal comprises a uniquely phased digital pattern; and
   low pass filtering each digital test signal to generate the plurality of the first and further periodic test signals ($D_{TEST}$), each of the plurality of the first and further periodic test signals ($D_{TEST}$) being a uniquely phased periodic test signal.

6. A method according to claim 5, in which the first periodic test signal ($D_{TEST}$) provided to test the first input circuit is arranged to have as great a phase separation as possible from a second periodic test ($D_{TEST}$) signal provided to test a second input circuit being adjacent to the first input circuit.

7. A method of detecting an open circuit in replicated input circuits, whereby each replicated input circuit receives a common input signal,
the method comprises the steps of
testing each replicated input circuit according to the method of claims 1-4, whereby the common input signal is the analog input signal
and wherein, for each replicated input circuit, the step of generating the first periodic test signal comprises generating the first periodic test signal having a small frequency difference with respect to the first periodic test signals generated for each other replicated input circuits, such that in the event of one of the replicated input circuits having an open circuit input, the extracted test signal corresponding to said one of the replicated input circuits exhibits a significant amplitude variation.

8. A method according to claim 7, in which the frequency difference between each periodic test signal ($D_{TEST}$) is substantially equal to 0.2%.

9. An apparatus for testing a first input circuit for receiving an analog input signal ($V_{IN}$) and producing a digital output signal, the apparatus comprising:

means (30,34) for generating a first symmetrical periodic test signal ($D_{TEST}$) having a predetermined phase and a predetermined amplitude;
an adder (11) for summing the first periodic test signal ($D_{TEST}$) and the analog input signal ($V_{IN}$) to provide a summed signal, wherein the summed signal is processed by the first input circuit (12, 13, 14) to provide a signal ($D_{OUT}$);
means (702, 703) for producing the digital output signal from the signal ($D_{OUT}$), wherein the means for producing the digital output signal comprises means for sampling the signal ($D_{OUT}$) and means for averaging samples of the signal ($D_{OUT}$) over a moving average time period equal to an integer multiple of the period of the first periodic test signal ($D_{TEST}$), wherein the sample period is such that the average value of the contribution from the first periodic test signal ($D_{TEST}$) to the digital output signal over said moving average period is equal to zero;
means (704,705) for generating an extracted test signal from the samples of the signal ($D_{OUT}$);

and
a comparator (707) for comparing the extracted test signal with a reference signal representing said first periodic test signal and for generating an error signal in dependence upon said comparison.

**Patentansprüche**

1. Verfahren zum Testen einer ersten Eingangsschaltung zum Empfangen eines analogen Eingangssignals ($V_{IN}$) und Erzeugen eines digitalen Ausgangssignals, wobei das Verfahren die folgenden Schritte umfasst:

Erzeugen eines ersten periodischen Testsignals ($D_{TEST}$) mit einer vorgegebenen Phase und einer vorgegebenen Amplitude;
**dadurch gekennzeichnet, dass** das Verfahren außerdem die folgenden Schritte umfasst:

Summieren des ersten periodischen Testsignals ($D_{TEST}$) und des analogen Eingangssignals ($V_{IN}$), um ein summiertes Signal bereitzustellen, wobei das erste periodische Signal ($D_{TEST}$) ein symmetrisches Signal umfasst;
Verarbeiten des summierten Signals durch die Eingangsschaltung, um ein Signal ($D_{OUT}$) bereitzustellen;
Erzeugen des digitalen Ausgangssignals aus dem Signal ($D_{OUT}$), worin das Erzeugen des digitalen Ausgangssignals umfasst, dass das Signal ($D_{OUT}$) abgetastet wird und Abtastwerte des Signals ($D_{OUT}$) über eine Zeitperiode des gleitenden Mittels gleich einem ganzzahligen Vielfachen der Periode des periodischen Testsignals ($D_{TEST}$) gemittelt werden, sodass der Mittelwert des Beitrags aus dem periodischen Testsignal ($D_{TEST}$) zum digitalen Ausgangssignal über die Periode des gleitenden Mittels gleich null ist;
Erzeugen eines extrahierten Testsignals aus den Abtastwerten des Signals ($D_{OUT}$),
Vergleichen des extrahierten Testsignals mit einem Referenzsignal (706), das das periodische Testsignal ($D_{TEST}$) repräsentiert; und
Erzeugen eines Fehlersignals in Abhängigkeit von dem Ergebnis des Vergleichsschritts.

2. Verfahren nach Anspruch 1, worin das erste periodische Testsignal ($D_{TEST}$) ein sinusförmiges Signal ist.

3. Verfahren nach Anspruch 1, worin die Zeitperiode des gleitenden Mittels gleich der Periode des ersten periodischen Testsignals ($D_{TEST}$) ist.

4. Verfahren nach einem der vorhergehenden Ansprüche, worin die Periode des ersten periodischen Testsignals ($D_{TEST}$) gleich 4 ms ist; das Signal ($D_{OUT}$) alle 1 ms abgetastet wird, und das gleitende Mittel der vorhergehenden vier Abtastwerte alle 1 ms erzeugt wird, sodass die Zeitperiode des gleitenden Mittels gleich 4 ms ist.

5. Verfahren nach einem der vorhergehenden Ansprüche, worin eine Vielzahl von weiteren Eingangsschaltungen getestet werden, wobei die Eingangsschaltungen der ersten Eingangsschaltung strukturell ähneln, wobei das Verfahren außerdem Folgendes umfasst:

    Erzeugen einer Vielzahl von weiteren periodischen Testsignalen ($D_{TEST}$), deren jedes einer jeweiligen der Vielzahl von weiteren Eingangsschaltungen bereitgestellt wird, worin das Erzeugen der Vielzahl von weiteren periodischen Testsignalen ($D_{TEST}$) Folgendes umfasst:

        Erzeugen einer digitalen Repräsentation, wobei die digitale Repräsentation eine Anzahl von Bits gleich der Anzahl der Vielzahl der ersten und weiteren periodischen Testsignalen ($D_{TEST}$) umfasst, die zu erzeugen sind;
        Speichern der digitalen Repräsentation in einem Schieberegister (30);
        Erzeugen einer Vielzahl von digitalen Testsignalen aus einer Vielzahl von Taps aus dem Schieberegister (30), sodass jedes digitale Testsignal ein eindeutig phasengesteuertes digitales Muster umfasst; und
        Niederpassfilterung eines jeden digitalen Testsignals, um die Vielzahl der ersten und weiteren periodischen Testsignale ($D_{TEST}$) zu erzeugen, wobei jedes der Vielzahl der ersten und weiteren periodischen Testsignale ($D_{TEST}$) ein eindeutig phasengesteuertes periodisches Testsignal ist.

6. Verfahren nach Anspruch 5, worin das erste periodische Testsignal ($D_{TEST}$), das zum Testen der ersten Eingangsschaltung bereitgestellt ist, dazu angeordnet ist, eine möglichst große Phasentrennung von einem zweiten periodischen Testsignal ($D_{TEST}$) zu haben, das zum Testen einer zweiten Eingangsschaltung bereitgestellt ist, die der ersten Eingangsschaltung benachbart ist.

7. Verfahren zum Detektieren einer offenen Schaltung in reproduzierten Eingangsschaltungen, wodurch jede reproduzierte Eingangsschaltung ein gemeinsames Eingangssignal empfängt,
wobei das Verfahren die folgenden Schritte umfasst:

    Testen jeder reproduzierten Eingangsschaltung nach dem Verfahren der Ansprüche 1-4, wodurch das gemeinsame Eingangssignal das analoge Eingangssignal ist;
    und worin für jede reproduzierte Eingangsschaltung der Schritt des Erzeugens des ersten periodischen Testsignals umfasst, dass das erste periodische Signal mit einer kleinen Frequenzdifferenz mit Bezug auf das erste periodische Testsignal erzeugt wird, die für jede andere reproduzierte Eingangsschaltung erzeugt wird, sodass für den Fall, dass eine der reproduzierten Eingangsschaltungen einen offenen Schaltungseingang hat, das extrahierte Testsignal, das einem der reproduzierten Eingangsschaltungen entspricht, eine signifikante Amplitudenvariation aufweist.

8. Verfahren nach Anspruch 7, worin die Frequenzdifferenz zwischen jedem periodischen Testsignal ($D_{TEST}$) im Wesentlichen gleich 0,2 % ist.

9. Vorrichtung zum Testen einer ersten Eingangsschaltung zum Empfangen eines analogen Eingangssignals ($V_{IN}$) und Erzeugen eines digitalen Ausgangssignals, wobei die Vorrichtung Folgendes umfasst:

    ein Mittel (30, 34) zum Erzeugen eines ersten symmetrischen periodischen Testsignals ($D_{TEST}$) mit einer vorgegebenen Phase und einer vorgegebenen Amplitude;
    einen Addierer (11) zum Summieren des ersten periodischen Testsignals ($D_{TEST}$) und des analogen Eingangssignals ($V_{IN}$), um ein summiertes Signal bereitzustellen, worin das summierte Signal von der ersten Eingangsschaltung (12, 13, 14) verarbeitet wird, um ein Signal ($D_{OUT}$) bereitzustellen;
    ein Mittel (702, 703) zum Erzeugen des digitalen Ausgangssignals aus dem Signal ($D_{OUT}$), worin das Mittel zum Erzeugen des digitalen Ausgangssignals ein Mittel zum Abtasten des Signals ($D_{OUT}$) und ein Mittel zum Mitteln von Abtastwerten des Signals ($D_{OUT}$) über eine Zeitperiode des gleitenden Mittels gleich einem ganzzahligen Vielfachen der Periode des ersten periodischen Testsignals ($D_{TEST}$) umfasst, worin die Abtastperiode so beschaffen ist, dass der Mittelwert des Beitrags aus dem ersten periodischen Testsignal ($D_{TEST}$) zum digitalen Ausgangssignal über die Periode des gleitenden Mittels gleich null ist;
    ein Mittel (704, 705) zum Erzeugen eines extrahierten Testsignals aus den Abtastwerten des Signals ($D_{OUT}$), und
einen Komparator (707) zum Vergleichen des extrahierten Testsignals mit einem Referenzsignal, das das erste periodische Testsignal repräsentiert, und zum Erzeugen eines Fehlersignals in Abhängigkeit von dem Vergleich.

## Revendications

1. Procédé pour tester un premier circuit d'entrée pour recevoir un signal d'entrée analogique ($V_{IN}$) et produire un signal de sortie numérique, le procédé comprenant les étapes suivantes :

   génération d'un premier signal de test périodique ($D_{TEST}$) ayant une phase prédéterminée et une amplitude prédéterminée ;
   **caractérisé en ce que** le procédé comprend en outre les étapes suivantes :

   sommation du premier signal de test périodique ($D_{TEST}$) et du signal d'entrée analogique ($V_{IN}$) pour fournir un signal sommé, le premier signal de test périodique ($D_{TEST}$) comprenant un signal symétrique ;
   traitement du signal sommé par le circuit d'entrée pour fournir un signal ($D_{OUT}$) ;
   production du signal de sortie numérique à partir du signal ($D_{OUT}$), dans lequel la production du signal de sortie numérique comprend l'échantillonnage du signal ($D_{OUT}$) et le moyennage des échantillons du signal ($D_{OUT}$) sur une période de temps à moyenne mobile égale à un multiple entier de la période du signal de test périodique ($D_{TEST}$) de sorte que la valeur moyenne de la contribution du signal de test périodique ($D_{TEST}$) au signal de sortie numérique sur ladite période à moyenne mobile soit égale à zéro ;
   génération d'un signal de test extrait à partir des échantillons du signal ($D_{OUT}$) ;
   comparaison du signal de test extrait avec un signal de référence (706) représentant ledit signal de test périodique ($D_{TEST}$) ; et
   génération d'un signal d'erreur en fonction du résultat de ladite étape de comparaison.

2. Procédé selon la revendication 1, dans lequel le premier signal de test périodique ($D_{TEST}$) est un signal sinusoïdal.

3. Procédé selon la revendication 1, dans lequel la période de temps à moyenne mobile est égale à la période du premier signal de test périodique ($D_{TEST}$).

4. Procédé selon l'une quelconque des revendications précédentes, dans lequel la période du premier signal de test périodique ($D_{TEST}$) est de 4 ms ; le signal ($D_{OUT}$) est échantillonné toutes les 1 ms, et la moyenne mobile des quatre échantillons précédents est générée toutes les 1 ms de sorte que la période de temps à moyenne mobile est de 4 ms.

5. Procédé selon l'une quelconque des revendications précédentes, dans lequel une pluralité d'autres circuits d'entrée sont testés, lesdits circuits d'entrée étant similaires quant à leur structure au premier circuit d'entrée, le procédé comprenant en outre :

   la génération d'une pluralité d'autres signaux de test périodiques ($D_{TEST}$) fournis chacun à un circuit respectif de la pluralité des autres circuits d'entrée, dans lequel la génération de la pluralité des autres signaux de test périodiques ($D_{TEST}$) comprend :

   la génération d'une représentation numérique, la représentation numérique comprenant un nombre de bits égal au nombre de la pluralité des premier et autres signaux de test périodiques ($D_{TEST}$) à générer ;
   la mémorisation de ladite représentation numérique dans un registre à décalage (30) ;
   la génération d'une pluralité de signaux de test numériques à partir d'une pluralité de prises à partir du registre à décalage (30) de sorte que chaque signal de test numérique comprenne un motif numérique à phase unique ; et
   le filtrage passe-bas de chaque signal de test numérique pour générer la pluralité des premier et autres signaux de test périodiques ($D_{TEST}$), chacun de la pluralité des premier et autres signaux de test périodiques ($D_{TEST}$) étant un signal de test périodique à phase unique.

6. Procédé selon la revendication 5, dans lequel le premier signal de test périodique ($D_{TEST}$) fourni pour tester le premier circuit d'entrée est agencé de manière à avoir une séparation de phase aussi grande que possible par rapport à un deuxième signal de test périodique ($D_{TEST}$) fourni pour tester un deuxième circuit d'entrée qui est adjacent au premier circuit d'entrée.

7. Procédé de détection d'un circuit ouvert dans des circuits d'entrée dupliqués, moyennant quoi chaque circuit d'entrée dupliqué reçoit un signal d'entrée commun,
   le procédé comprenant les étapes de test de chaque circuit d'entrée dupliqué conformément au procédé des revendications 1 à 4,

moyennant quoi le signal d'entrée commun est le signal d'entrée analogique ;

et dans lequel, pour chaque circuit d'entrée dupliqué, l'étape de génération du premier signal de test périodique comprend la génération du premier signal de test périodique ayant une petite différence de fréquence par rapport au premier signal de test périodique généré pour chaque autre circuit d'entrée dupliqué, de sorte que dans le cas où l'un des circuits d'entrée dupliqués a une entrée en circuit ouvert, le signal de test extrait correspondant audit un des circuits d'entrée dupliqués présente une variation d'amplitude significative.

8. Procédé selon la revendication 7, dans lequel la différence de fréquence entre chacun des signaux de test périodiques ($D_{TEST}$) est sensiblement égale à 0,2 %.

9. Appareil pour tester un premier circuit d'entrée pour recevoir un signal d'entrée analogique ($V_{IN}$) et produire un signal de sortie numérique, l'appareil comprenant :

des moyens (30, 34) pour générer un premier signal de test périodique ($D_{TEST}$) symétrique ayant une phase prédéterminée et une amplitude prédéterminée ;

un additionneur (11) pour additionner le premier signal de test périodique ($D_{TEST}$) et le signal d'entrée analogique ($V_{IN}$) pour fournir un signal sommé, dans lequel le signal sommé est traité par le premier circuit d'entrée (12, 13, 14) pour fournir un signal ($D_{OUT}$) ;

des moyens (702, 703) pour produire le signal de sortie numérique à partir du signal ($D_{OUT}$), dans lequel les moyens pour produire le signal de sortie numérique comprennent des moyens pour échantillonner le signal ($D_{OUT}$) et des moyens pour moyenner les échantillons du signal ($D_{OUT}$) sur une période de temps à moyenne mobile égale à un multiple entier de la période du premier signal de test périodique ($D_{TEST}$), dans lequel la période d'échantillonnage est telle que la valeur moyenne de la contribution du premier signal de test périodique ($D_{TEST}$) au signal de sortie numérique sur ladite période à moyenne mobile est égale à zéro ;

des moyens (704, 705) pour générer un signal de test extrait à partir des échantillons du signal ($D_{OUT}$) ; et

un comparateur (707) pour comparer le signal de test extrait avec un signal de référence représentant ledit premier signal de test périodique et pour générer un signal d'erreur en fonction de ladite comparaison.

EP 1 837 670 B1

FIELD
INPUT

1

| FIELD TERMINATION ASSEMBLY | INPUT MODULE | TMR PROCESSOR | OUTPUT MODULE | FIELD TERMINATION ASSEMBLY |

2     3     5     4     5     6     7

COMMUNICATION INTERFACE

8

10

Figure 1

Figure 2

Figure 3

Figure 4a    **Sinusoids**

Figure 4b    **Digital PRM[1]**

**Digital PRM[2]**

**Digital PRM[3]**

Figure 4c    **Filtered PRM[1]**

**Filtered PRM[2]**

**Filtered PRM[3]**

Figure 4d

| Mode | Offset | Amplitude | PRM Pattern |
|------|--------|-----------|-------------|
| Analog | 3.125 V | 0.5V | 010010001001001001010101010101010010100100 |
| Digital | 3.75 V | 0.5V | 010000001000001000100010010101001001000100 |

Average over 4 samples = 0

Average over 8 samples = 0

Average over 8 samples = 0

Average over 16 samples = 0

Average over 6 samples = 0

Average over 12 samples = 0

Figure 5

Fig. 6

volts

Active & Standby

-2   -1   0   1   2

secs

3.5  3.4  3.3  3.2  3  2.9  2.8  2.7  2.6  2.5

EP 1 837 670 B1

Fig. 7

```
                                                            ┌──────────┐  707
                                                  ┌─────────┤ Compare  │
                                         Phase     │    ┌───┤          ├──→ error
                                    ┌──────────────┘    │   │          │
                            ┌───────┴────┐              │   │          │
                            │ Test signal │  Mag        │   │          │
                 706 ───────┤  Reference  ├─────────────┘   │          │
                            │            │                  └────┬─────┘
                            └────────────┘                  Mag  │ Phase
                                                      ┌──────────┴──────┐  705
                                                      │ Polar           │
                                                      │ Co-ordinate     │
                                                      │ generator       │
                                                      └───┬─────────┬───┘
                                                       Im │         │ Re
                                                      ┌───┴─────────┴───┐  704
                                                      │      DFT        │
                                                      └──┬──┬──┬──┬─────┘
                                                         ↑  ↑  ↑  ↑
                                                      ┌──┴──┴──┴──┴──┐  703
                                                      │ 4ms Block    │
       16 bit digital output ←────────────────────────┤ averager    │
                                                      └──────┬───────┘
                                              702            │
                                         ┌──────┴──────┐     │
                                         │ 1ms         ├─────┘
                                         │ accumulator │
                                         └──────┬──────┘
                                   701          │
                              ┌──────┴──────┐   │
                              │ Optical     ├───┘
                              │ Isolation   │
                              └──────┬──────┘
                        10           │
                   ┌──────┴──────┐   │
                   │ Sigma       ├───┘
          V_IN ───→│ Delta ADC   │
                   └─────────────┘
```

**EP 1 837 670 B1**

## REFERENCES CITED IN THE DESCRIPTION

### Patent documents cited in the description

- DE 19750349

- US 6351835 B